# EUROPÄISCHE PATENTSCHRIFT

(11) **EP 0 485 828 B1**
(45) Veröffentlichungstag und Bekanntmachung des Hinweises auf die Patenterteilung: **22.02.1995**
(21) Anmeldenummer: 91118704.5
(22) Anmeldetag: 02.11.1991
(51) Int. Cl.: H04B 10/14, H03H 7/46

(54) **Optischer Empfänger**
Optical receiver
Récepteur optique

(30) Priorität: 15.11.1990 DE 4036411
(43) Veröffentlichungstag der Anmeldung: 20.05.1992
(73) Patentinhaber: Alcatel SEL Aktiengesellschaft, D-70435 Stuttgart (DE); ALCATEL N.V., NL-1077 XX Amsterdam (NL)
(72) Erfinder: Krimmel, Heinz, W-7000 Stuttgart 30 (DE)
(74) Vertreter: Pohl, Herbert, Dipl.-Ing.

(56) Entgegenhaltungen:
- EP-A- 0 372 742
- US-A- 4 207 532
- PATENT ABSTRACTS OF JAPAN vol. 7, no. 229 (E-203)(1374) 12. Oktober 1983 & JP-A-58 119 242

## Beschreibung

Die Erfindung betrifft einen optischen Empfänger für in Frequenzgetrenntlage vorzugsweise auf einer Glasfaser übertragene Breitband- und Schmalbandsignale, insbesondere Analogsignale, mit einer Vorstufe, die einen Symmetrier- und Impedanz-Transformator und einen Breitbandverstärker aufweist.

Der Gegenstand der Erfindung ist insbesondere in einem optischen Teilnehmeranschlußsystem mit analog-optischer Übertragung, zum Beispiel Kabelfernsehübertragung, und analog-optisch übertragenen Schmalbanddiensten, zum Beispiel Telefon oder dergleichen, einsetzbar. Der optische Empfänger dient dazu, die einzelnen Signale, also das Breitbandsignal und das Schmalbandsignal zu verarbeiten.

Ein optischer Breitbandempfänger mit einem Impedanztransformator in der Vorstufe ist aus dem Dokument EP-A- 372 742, bekannt.

Bekannt ist es weiterhin, eine optische Aufteilung des empfangenen Signals, zum Beispiel mit einem Faserkoppler, vorzunehmen. Dies führt jedoch zu einem zusätzlichen Signalverlust im kritischen Power Budget des Breitbandsignals.

Der Erfindung liegt daher die Aufgabe zugrunde einen optischen Empfänger der eingangs genannten Art zu schaffen, bei dem keine Einbuße der Signalqualität eintritt und eine optimale Verarbeitung bei geringem Aufwand möglich ist.

Diese Aufgabe wird erfindungsgemäß dadurch gelöst, daß der Symmetrier- und Impedanz-Transformator zur Abtrennung des Schmalbandsignals eine separate Wicklung aufweist, an die ein separater, selektiver Vorverstärker angeschlossen ist. Damit wird ein schmaler Frequenzbereich magnetisch ausgekoppelt und separat verarbeitet. Gegenüber einer gemeinsamen, aus dem Stand der Technik bekannten Verarbeitung des Breitband- und des Schmalbandsignals ergibt sich der Vorteil, daß kein zusätzlicher Signalverlust im kritischen Power Budget des Breitbandsignals zu verzeichnen ist. Ferner kann der separate, selektive Vorverstärker für das Schmalbandsignal rauschärmer realisiert werden, das heißt, es ergibt sich ein besseres Signal/Rausch-Verhältnis.

Die Realisierung der weiteren, separaten Windungen für die Auskopplung des Schmalbandsignals erfordert kaum einen Aufwand. Diese weitere Wicklung wird zusätzlich auf dem Kern des Transformators vorgesehen; sie kann unter Umständen aus nur einer Windung bestehen.

Nach einer Weiterbildung der Erfindung ist vorgesehen, daß der Symmetrier- und Impedanz-Transformator ein Ringkern-Transformator ist.

Vorteilhaft ist es ferner, wenn dem Vorverstärker für das Schmalbandsignal eine Notstromversorgung zugeordnet ist. Die Energie hierfür kann beispielsweise von einem Akkumulator stammen. Fällt die Stromversorgung (Netz) für den optischen Empfänger aus, so läßt sich ein Notbetrieb für die Schmalbanddienste (zum Beispiel Telefon, Telefax usw.) aus dem Akkumulator vorsehen. Bei dem Breitbandverstärker, also der Verarbeitungsstufe für das Breitbandsignal (zum Beispiel Kabelfernsehübertragung, FM-Stereo-Rundfunkübertragung) ist es unwirtschaftlich, auch dort eine Notstromversorgung vorzusehen, da der Leistungsbedarf des Breitbandverstärkers relativ groß ist. Überdies ist bei einem Netzausfall der Weiterbetrieb der Schmalbanddienste als wichtiger gegenüber den Breitbanddiensten einzustufen.

Die Zeichnungen veranschaulichen die Erfindung anhand eines Ausführungsbeispiels und zwar zeigt:
- Figur 1: ein Frequenz-Diagramm optischer Breitband- und Schmalbanddienste,
- Figur 2: ein Prinzipschaltbild eines optischen Empfängers und
- Figur 3: ein Symmetrier- und Impedanz-Transformator des Empfängers in schematischer Darstellung.

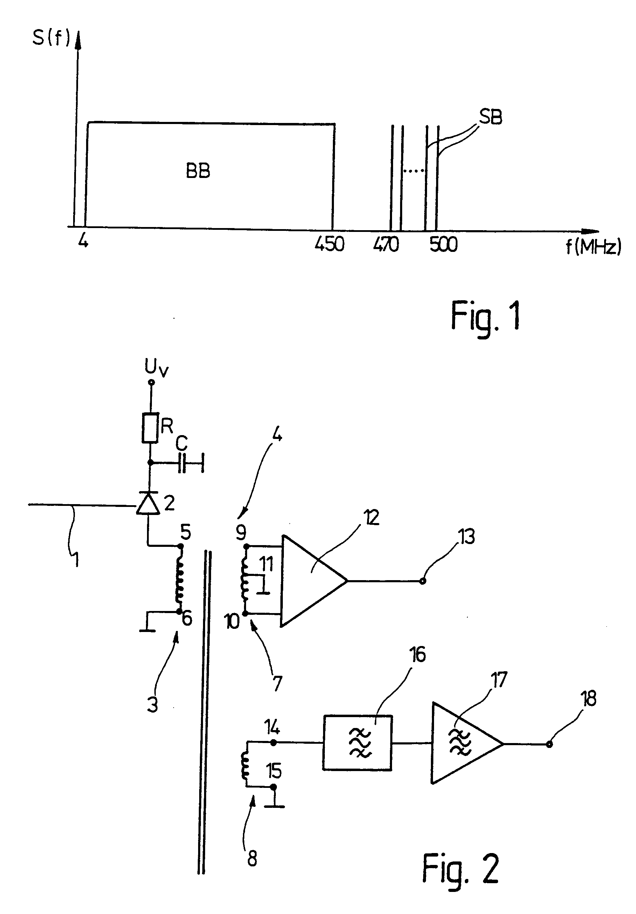

Die Figur 1 zeigt einen Frequenzplan der Dienste eines optischen Teilnehmeranschlussystems zum Beispiel mit analog-optischer Kabelfernseh- und FM-Rundfunkübertragung und analog übertragenen Schmalbanddiensten. Das Signal S weist im Bereich der Frequenz von 4 bis 450 MHz ein Breitbandsignal auf. Dies kann beispielsweise 35 TV-Kanäle und 30 FM-Stereokanäle betreffen.

Im Bereich von zum Beispiel 470 bis 500 MHz sind verschiedene Schmalbanddienste angeboten. Dabei kann es sich zum Beispiel um Telefonübertragung und Telefaxübertragung handeln. Das Breitbandsignal ist in der Figur 1 mit BB und das Schmalbandsignal mit SB gekennzeichnet.

Das Signal S wird einem optischen Empfänger gemäß der Figur 2 über einen Lichtwellenleiter 1 zugeführt. Beispielsweise wird eine Pin-Fotodiode 2 angesteuert. Diese ist über einen Widerstand R an eine Versorgungsspannung U_{V} angeschlossen, wobei zwischen Widerstand R und Pin-Fotodiode 2 ein Kondensator C liegt, der nach Masse führt. Ferner steht der andere Anschluß der Pin-Fotodiode 2 mit einer Primärwicklung 3 eines Symmetrier- und Impedanz-Transformators 4 in Verbindung. Die Anode der Pin-Fotodiode 2 führt zu einem Anschluß 5 der Primärwicklung, deren anderer Anschluß 6 nach Masse führt.

Der Symmetrier- und Impedanz-Transformator 4 weist erfindungsgemäß zwei Sekundärwicklungen 7 und 8 auf. Die Sekundärwicklung 7 dient der Auskopplung des Breitbandsignals BB; sie weist einen Anschluß 9 und einen Anschluß 10 und einen Mittelanschluß 11 auf. Die Anschlüsse 9 und 10 führen zu einem Breitbandverstärker 12, der eine hohe Linearität aufweist und rauscharm ist. Dieser Breitbandverstärker 12 hat einen relativ hohen Leistungsbedarf. Am Ausgang 13 des Breitbandverstärkers 12 steht beispielsweise ein Signal im Frequenzbereich zwischen 4 und 450 MHz zur Verfügung.

Ferner ist auf den Kern des Symmetrier- und Impedanz-Transformators 4 die zweite Sekundärwicklung 8 aufgewickelt, die die Anschlüsse 14 und 15 aufweist. Der Anschluß 14 führt zu einem Filter 16 (Bandfilter), dessen Ausgang mit einem Vorverstärker 17 verbunden ist. Am Ausgang 18 des Vorverstärkers 17 steht ein Schmalbandsignal SB zur Verfügung, zum Beispiel im Frequenzbereich 490 MHz ± Δ f. Der Vorverstärker 17 ist schmalbandig ausgebildet; seine Rauscheigenschaften sind optimiert; er hat nur einen sehr kleinen Leistungsbedarf.

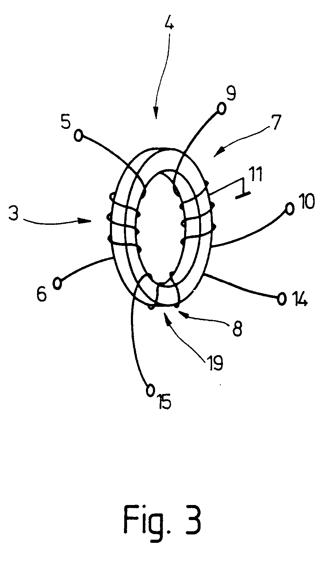

Aus der Figur 3 ist -in schematischer Darstellungder Aufbau des Symmetrier- und Impedanz-Transformators 4 ersichtlich. Die erfindungsgemäße separate Wicklung 19, die von der Sekundärwicklung 8 gebildet ist und der Auskopplung des Schmalbandsignals SB dient, ist dort mit drei Windungen dargestellt. Je nach Bauform ist es jedoch auch möglich, daß diese Wicklung 19 nur von einer Windung gebildet wird.

Nach einem nicht dargestellten Ausführungsbeispiel kann vorgesehen sein, daß der separate selektive Vorverstärker 17 mit einer Notstromversorung versehen ist. Bei Ausfall der Stromversorgung (Netz) läßt sich dann ein Notbetrieb für die Schmalbanddienste durchführen. Dies ist insbesondere deshalb möglich, weil der Vorverstärker 17 nur einen sehr geringen Leistungsbedarf hat.

## Patentansprüche

1. Optischer Empfänger für in Frequenzgetrenntlage übertragene Breitband- und Schmalbandsignale, insbesondere Analogsignale, mit einer Vorstufe, die einen Symmetrier- und Impedanz-Transformator und einen Breitbandverstärker aufweist, **dadurch gekennzeichnet**, daß der Symmetrier- und Impedanz-Transformator (4) zur Abtrennung des Schmalbandsignals (SB) eine separate Wicklung (19) aufweist, an die ein separater, selektiver Vorverstärker (17) angeschlossen ist.

2. Empfänger nach Anspruch 1, **dadurch gekennzeichnet**, daß der Symmetrier- und Impedanz-Transformator (4) ein Ringkern-Transformator ist.

3. Optischer Empfänger nach einem der vorhergehenden Ansprüche, **dadurch gekennzeichnet**, daß dem Vorverstärker (17) eine insbesondere von einem Akkumulator gespeiste Notstrom-Versorgung zugeordnet ist.

4. Optischer Empfänger nach einem der vorhergehenden Ansprüche, **dadurch gekennzeichnet**, daß zwischen der Wicklung (19) und dem Vorverstärker (17) ein Filter (16) geschaltet ist.

## Claims

1. Optical receiver for broadband and narrowband signals transmitted in the frequency-separated state, in particular analogue signals, with a preliminary stage exhibiting a balanced-to-unbalanced and impedance transformer and a broadband amplifier, characterised in that the balanced-to-unbalanced and impedance transformer (4) for separating the narrowband signal (SB) exhibits a separate winding (19), to which a separate, selective preamplifier (17) is connected.

2. Receiver according to Claim 1, characterised in that the balanced-to-unbalanced and impedance transformer (4) is a toroidal transformer.

3. Optical receiver according to one of the preceding claims, characterised in that an emergency power supply, supplied in particular from a storage battery, is assigned to the preamplifier (17).

4. optical receiver according to one of the preceding claims, characterised in that a filter (16) is connected between the winding (19) and the preamplifier (17).

## Revendications

1. Récepteur optique pour signaux à large bande et à bande étroite, en particulier signaux analogiques, transmis sur deux plages de fréquence différentes, comportant un étage préliminaire qui présente un transformateur de symétrisation et d'impédance et un amplificateur à large bande, caractérisé par le fait que le transformateur de symétrisation et d'impédance (4) présente, pour la séparation du signal à bande étroite (SB), un enroulement distinct (19) auquel est relié un préamplificateur sélectif distinct (17).

2. Récepteur selon la revendicaiton 1, caractérisé par le fait que le transformateur de symétrisation et d'impédance (4) est un transformateur de type toroïdal.

3. Récepteur optique selon l'une des revendications précédentes, caractérisé par le fait qu'au préamplificateur (17) correspond une alimentation de secours alimentée en particulier par un accumulateur.

4. Récepteur optique selon l'une des revendications précédente, caractérisé par le fait qu'entre l'enroulement (19) et le préamplificateur (17) est monté un filtre (16).
